# EUROPEAN PATENT APPLICATION

(11) **EP 4 654 797 A1**
(43) Date of publication of application: **26.11.2025**
(21) Application number: 25177099.6
(22) Date of filing: 16.05.2025
(51) Int. Cl.: H10K 59/122, H10K 59/32

(54) **DISPLAY DEVICE**

(30) Priority: 23.05.2024 KR 20240067258
(71) Applicant: Samsung Display Co., Ltd., Yongin-si, Gyeonggi-do 17113 (KR)
(72) Inventor: KIM, Daesoo, 17113 Yongin-si (KR); CHO, Hyunmin, 17113 Yongin-si (KR)
(74) Representative: Marks & Clerk LLP

(57) **Abstract**

A display device including a pixel electrode, a bank layer including a first opening and a first overhang portion, a bank structure layer on the bank layer and including a second opening overlapping the first opening, an intermediate layer overlapping the pixel electrode, and an opposite electrode on the intermediate layer. The bank structure layer includes a first layer on an upper surface of the bank layer and including a first insulating material, and a second layer on the upper surface of the first layer and including a second insulating material. The second layer includes a second overhang portion protruding toward a center of the second opening from a point where a bottom surface of the second layer and a side surface of the first layer meet, and sub-layers of the intermediate layer include multiple portions separated by the first and second overhang portions.

## Description

### BACKGROUND

### 1. Technical Field

One or more embodiments relate to a display device.

### 2. Description of the Related Art

In accordance with the development of display devices that visually display electrical signals, various display devices have been introduced having excellent characteristics such as thin design, light weight, and low power consumption. As the demand for providing high-quality images in display devices continues, display devices having various structures are being developed.

### SUMMARY

One or more embodiments include a display device for providing high quality images at high resolution.

Additional aspects will be set forth in part in the description which follows and, in part, will be apparent from the description, or may be learned by practice of the presented embodiments of the disclosure.

According to one or more embodiments, a display device may include a pixel electrode, a bank layer including an inorganic insulating material, a first opening, and a first overhang portion, the first opening overlapping the pixel electrode, and the first overhang portion being disposed over an upper surface of the pixel electrode, a bank structure layer disposed on the bank layer and including a second opening overlapping the first opening, an intermediate layer overlapping the pixel electrode through the first opening and the second opening, and an opposite electrode disposed on the intermediate layer, wherein the bank structure layer includes a first layer disposed on an upper surface of the bank layer and including a first insulating material, and a second layer disposed on an upper surface of the first layer and including a second insulating material, the second layer including a second overhang portion protruding toward a center of the second opening from a point where a bottom surface of the second layer and a side surface of the first layer meet, sub-layers of the intermediate layer include a plurality of portions separated by the first overhang portion and the second overhang portion, and the opposite electrode overlaps the plurality of portions.

The intermediate layer may include a charge generation layer. The intermediate layer may include a first light-emitting unit between the charge generation layer and the pixel electrode. The intermediate layer may include a second light-emitting unit between the charge generation layer and the opposite electrode. Sub layers of the first light-emitting unit may each include portions separated by the first overhang portion and the second overhang portion. The charge generation layer may include portions separated by the first overhang portion and the second overhang portion.

At least one of sub-layers of the second light-emitting unit may include portions separated by the first overhang portion and the second overhang portion.

A thickness of a portion of the bank layer that overlaps the bank structure layer may be greater than a thickness of the bank structure layer.

A first thickness of the first layer may be greater than a second thickness of the second layer.

The first thickness of the first layer may be in a range of about 800 angstroms to about 1,200 angstroms.

A ratio (t2/t1) of the second thickness (t2) of the second layer to the first thickness (t1) of the first layer may satisfy 0.4 < t2/t1 < 0.65.

A length of the second overhang portion may be in a range of about 0.05 micrometers to about 0.1 micrometers.

In some examples, the first overhang portion and the second overhang portion may not overlap each other when viewed in a direction perpendicular to an upper surface of the pixel electrode.

The upper surface of the bank layer may include a first portion overlapping the bank structure layer, and a second portion forming a step with respect to the first portion.

In a cross-sectional view, a horizontal distance from an imaginary line passing through a center of the pixel electrode to the step may be greater than a horizontal distance from the imaginary line to a point where the bank layer and the pixel electrode contact each other.

The display device may further include a protective layer between the upper surface of the bank layer and a bottom surface of the bank structure layer.

The bank structure layer may further include a third layer disposed on the second layer. The bank structure may include a fourth layer disposed on the third layer. The fourth layer may include a third overhang portion protruding toward the center of the second opening from a point where a bottom surface of the fourth layer and a side surface of the third layer meet.

According to one or more embodiments, a display device may include a pixel electrode, a bank structure layer disposed on the pixel electrode and including a first opening overlapping the pixel electrode, an intermediate layer overlapping the pixel electrode through the first opening of the bank structure layer, and an opposite electrode on the intermediate layer, wherein the bank structure layer includes a first layer including a first insulating material, a second layer disposed on an upper surface of the first layer and including a second insulating material, a third layer disposed on an upper surface of the second layer and including a third insulating material, and a fourth layer disposed on an upper surface of the third layer and including a fourth insulating material, the second layer includes a first overhang portion protruding toward a center of the first opening from a point where a bottom surface of the second layer and a side surface of the first layer meet, the fourth layer includes a second overhang portion protruding toward the center of the first opening from a point where a bottom surface of the fourth layer and a side surface of the third layer meet, and sub-layers included in the intermediate layer include portions separated by the first overhang portion and the second overhang portion.

The first insulating material and the third insulating material may be the same as each other. The second insulating material and the fourth insulating material may be the same as each other.

At least one selected from the first layer and the third layer may have a thickness in a range of about 500 angstroms to about 1,000 angstroms.

In some examples, the first overhang portion and the second overhang portion may not overlap each other.

In a cross-sectional view, a horizontal distance from an imaginary line passing through a center of the pixel electrode to the first overhang portion may be less than a horizontal distance from the imaginary line to the second overhang portion.

The display device may further include a bank layer between the pixel electrode and the bank structure layer. The bank layer may include a second opening overlapping the first opening of the bank structure layer.

The bank layer may include an overhang portion disposed on an upper surface of the pixel electrode.

In some examples, the overhang portion of the bank layer may not overlap the first overhang portion and the second overhang portion.

The intermediate layer may include a charge generation layer. The intermediate layer may include a first light-emitting unit between the charge generation layer and the pixel electrode. The intermediate layer may include a second light-emitting unit between the charge generation layer and the opposite electrode. Sub-layers of the first light-emitting unit may each include portions separated by the first overhang portion and the second overhang portion. The charge generation layer may include portions separated by the first overhang portion and the second overhang portion.

At least one of sub-layers of the second light-emitting unit may include portions separated by the first overhang portion and the second overhang portion.

In some examples, the opposite electrode may not be separated by the first overhang portion and the second overhang portion.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view illustrating a display device, according to an embodiment;
FIG. 2 is a schematic cross-sectional view illustrating part of a display device according to an embodiment;
FIG. 3 is an enlarged schematic cross-sectional view of a bank layer and a bank structure layer of a display device according to an embodiment;
FIG. 4 is a schematic diagram schematically illustrating a stack structure of a light-emitting diode of a display device according to an embodiment;
FIG. 5 is an enlarged schematic cross-sectional view of region V in part of the display device illustrated in FIG. 2, according to an embodiment;
FIG. 6 is an enlarged schematic cross-sectional view of region VI in part of the display device illustrated in FIG. 2, according to an embodiment;
FIG. 7A is a schematic cross-sectional view of a bank layer and a bank structure layer of a display device according to an embodiment;
FIG. 7B is a schematic cross-sectional view of a bank layer and a bank structure layer of a display device according to an embodiment;
FIG. 7C is a schematic cross-sectional view of a bank layer and a bank structure layer of a display device according to an embodiment; and
FIGS. 8A to 8F are schematic cross-sectional views showing a process of manufacturing a display device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the description.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

While such terms as "first" and "second" may be used to describe various elements, such elements should not be limited to the above terms. The above terms are used to distinguish one element from another.

The singular forms "a," "an," and "the" as used herein are intended to include the plural forms as well unless the context clearly indicates otherwise.

It will be understood that the terms "comprise," "comprising," "has," "have," "having," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. For example, intervening layers, regions, or elements may be present.

Sizes of elements in the drawings may be exaggerated or reduced for convenience of explanation. As an example, the size and thickness of each element shown in the drawings may be arbitrarily represented for convenience of description, and thus, the disclosure is not necessarily limited thereto.

In the case where a certain embodiment may be implemented differently, a specific process order may be performed in an order different from the described order. For example, two processes successively described may be performed substantially simultaneously or may be performed in the reverse order.

It will be understood that when a layer, region, or element is referred to as being "connected" to another layer, region, or element, it may be "directly connected" to the other layer, region, or element or may be "indirectly connected" to the other layer, region, or element with another layer, region, or element located therebetween. It will be understood that the terms "connected to" or "coupled to" may include a physical or electrical connection or coupling.

When an element is referred to as being "in contact" or "contacting" or the like to another element, the element may be in "electrical contact" or in "physical contact" with another element; or in "indirect contact" or in "direct contact" with another element.

The x-axis, the y-axis and the z-axis are not limited to three axes of a rectangular coordinate system, and may be interpreted in a broader sense. For example, the x-axis, the y-axis, and the z-axis may be perpendicular to one another, or may represent different orientations that are not perpendicular to one another.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. When an element is described as "not overlapping" or "to not overlap" another element, this may include that the elements are spaced apart from each other, offset from each other, or set aside from each other or any other suitable term as would be appreciated and understood by those of ordinary skill in the art.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

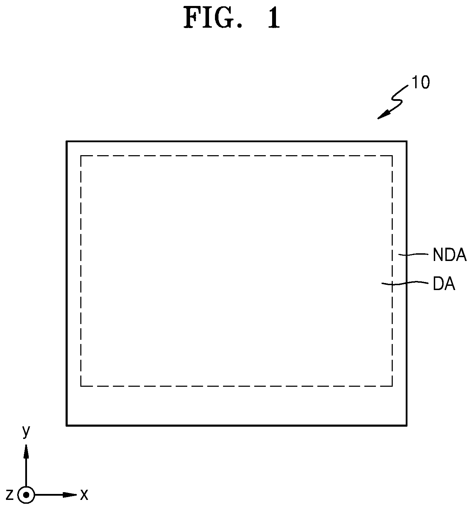

FIG. 1 is a schematic plan view illustrating a display device 10, according to an embodiment.

Referring to FIG. 1, the display device 10 may include a display area DA where an image is displayed and a non-display area NDA outside the display area DA. The display area DA may be entirely surrounded by the non-display area NDA.

In a plan view, the display area DA may have a rectangular shape. In another embodiment, the display area DA may have a polygonal shape (e.g., a triangular shape, a pentagonal shape, or a hexagonal shape), a circular shape, an elliptical shape, or an irregular shape. The display area DA may have a shape with rounded corners.

The display device 10 is a device for displaying video images or still images and may be used in a portable electronic device such as a laptop, a tablet personal computer (PC), a mobile phone, a smartphone, a mobile communication terminal, an electronic organizer, an electronic book, a portable multimedia player (PMP), a navigation device, or an ultra-mobile PC (UMPC). Also, the display device 10 may be used in an electronic device such as a television, a laptop computer, a monitor, an advertisement board, or an Internet of things (IoT) device or may be used in a wearable electronic device such as a smart watch, a watch phone, a glasses-type display, or a head-mounted display (HMD). Also, the display device 10 according to an embodiment may be used in an electronic device for display such as a center information display (CID) located on an instrument panel, a center fascia or a dashboard of a vehicle, a room mirror display replacing a side-view mirror of a vehicle, or a display screen located on the back of a front seat for entertainment for a back seat of a vehicle.

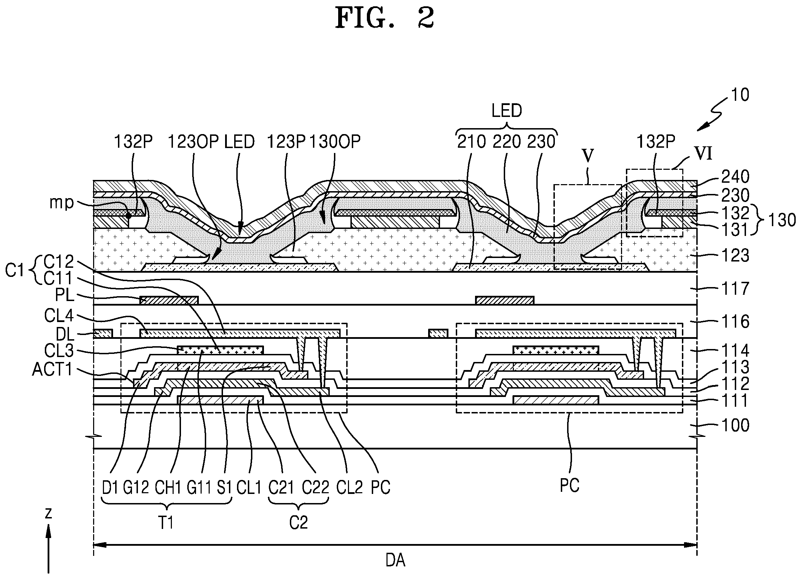

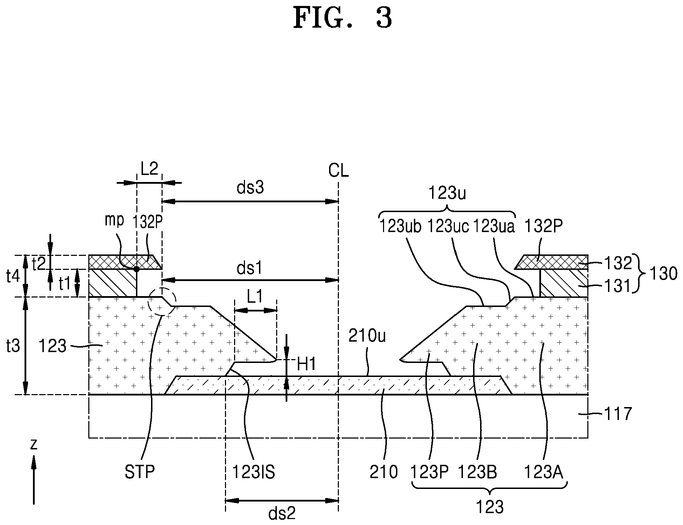

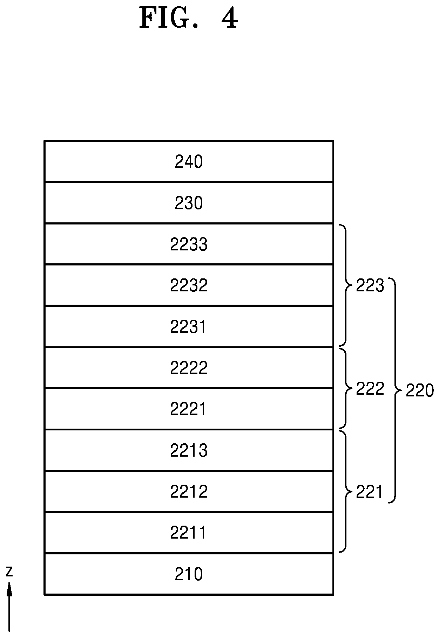

FIG. 2 is a schematic cross-sectional view illustrating part of the display device 10, according to an embodiment, and FIG. 2 shows pixel circuits PC and light-emitting diodes LED arranged in a portion of the display area DA. FIG. 3 is an enlarged schematic cross-sectional view of a bank layer 123 and a bank structure layer 130 of the display device 10 according to an embodiment, and FIG. 4 is a schematic diagram schematically illustrating a stack structure of a light-emitting diode LED of the display device 10 according to an embodiment.

Referring to FIG. 2, the display device 10 may include a substrate 100, the pixel circuits PC located on the substrate 100, and light-emitting diodes LED respectively electrically connected to the pixel circuits PC.

The substrate 100 may include a glass material or polymer resin. In an embodiment, the substrate 100 may have an alternating stacked structure of a base layer including polymer resin and a barrier layer including an inorganic insulating material such as silicon oxide or silicon nitride. The polymer resin may include a polymer resin such as polyethersulfone, polyarylate, polyetherimide, polyethylene naphthalate, polyethylene terephthalate, polyphenylene sulfide, polyimide, polycarbonate, cellulose triacetate, or cellulose acetate propionate.

The pixel circuit PC may include a transistor and a capacitor, and in this regard, FIG. 2 illustrates a first transistor T1, a first capacitor C1, and a second capacitor C2. The pixel circuit PC may include conductive layers and a semiconductor layer, constituting the transistor or the capacitor.

A first conductive layer CL1 may be located on the substrate 100. The first conductive layer CL1 may include a conductive material such as a metal. For example, the first conductive layer CL1 may include a conductive material including molybdenum (Mo), aluminum (Al), copper (Cu), titanium (Ti) or the like and may have a single or multi-layer structure including the above-mentioned material.

A buffer layer 111 may be located on the first conductive layer CL1. The buffer layer 111 may include an inorganic insulating material such as silicon oxide, silicon nitride, or silicon oxynitride, and may have a single layer or a multi-layer structure including the inorganic insulating material described above.

A second conductive layer CL2 may be located on the buffer layer 111 and may overlap the first conductive layer CL1. In an embodiment, the first conductive layer CL1 may include a first electrode C21 of the second capacitor C2, and the second conductive layer CL2 may include a second electrode C22 of the second capacitor C2. The second conductive layer CL2 may include a conductive material including molybdenum (Mo), aluminum (Al), copper (Cu), titanium (Ti), or the like and may have a single or multi-layer structure including the above-mentioned material.

A first insulating layer 112 may be located on the second conductive layer CL2. The first insulating layer 112 may include an inorganic insulating material such as silicon oxide, silicon nitride, or silicon oxynitride, and may have a single layer or a multi-layer structure including the inorganic insulating material described above.

A semiconductor layer ACT1 may be located on the first insulating layer 112. The semiconductor layer ACT1 may include a channel region CH1, and a source region S1 and a drain region D1, the source region S1 and the drain region D1 being located on both sides of the channel region CH1. The semiconductor layer ACT1 may include an oxide of at least one material selected from the group consisting of indium (In), gallium (Ga), tin (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). For example, the semiconductor layer ACT1 may be an InSnZnO (ITZO) semiconductor layer or an InGaZnO (IGZO) semiconductor layer. A conductive process by plasma treatment or the like may be performed on a part of the semiconductor layer ACT1. In another embodiment, the semiconductor layer ACT1 may include polysilicon, and a portion of the semiconductor layer ACT1 may be doped with impurities.

A third conductive layer CL3 may be located on the semiconductor layer ACT1 with a second insulating layer 113 between the third conductive layer CL3 and the semiconductor layer ACT1. A part of the third conductive layer CL3 may include a 1-1 gate electrode G11 overlapping the channel region CH1, and a part of the second conductive layer CL2 may include a 1-2 gate electrode G12 overlapping the channel region CH1. The 1-1 gate electrode G11 and the 1-2 gate electrode G12 may overlap each other with the channel region CH1 between the 1-1 gate electrode G11 and the 1-2 gate electrode G12. The second insulating layer 113 may include an inorganic insulating material such as silicon oxide, silicon nitride, or silicon oxynitride, and may have a single layer or a multi-layer structure including the inorganic insulating material described above.

A third insulating layer 114 may be located on the third conductive layer CL3. The third insulating layer 114 may include an inorganic insulating material such as silicon oxide, silicon nitride, or silicon oxynitride, and may have a single layer or a multi-layer structure including the inorganic insulating material described above.

The third conductive layer CL3 may include a first electrode C11 of the first capacitor C1, and a fourth conductive layer CL4 on the third insulating layer 114 may include a second electrode C12 of the first capacitor C1. Each of the third conductive layer CL3 and the fourth conductive layer CL4 may include a conductive material including molybdenum (Mo), aluminum (Al), copper (Cu), titanium (Ti), or the like and may have a single or multi-layer structure including the above material.

A data line DL may be located on the third insulating layer 114. The data line DL may include a conductive material including molybdenum (Mo), aluminum (Al), copper (Cu), titanium (Ti), or the like and may have a single or multi-layer structure including the above-mentioned material.

A fourth insulating layer 116 may be located on the data line DL. The fourth insulating layer 116 may include an organic insulating material such as acryl, benzocyclobutene (BCB), polyimide, or hexamethyldisiloxane (HMDSO).

A driving voltage line PL may be located on the fourth insulating layer 116 and may be covered by a fifth insulating layer 117. The driving voltage line PL may include a conductive material including molybdenum (Mo), aluminum (Al), copper (Cu), titanium (Ti), or the like and may have a single or multi-layer structure including the above-mentioned material. The fifth insulating layer 117 may include an organic insulating material.

FIG. 2 shows that the pixel circuit PC includes the second capacitor C2 disposed under the first transistor T1, but the disclosure is not limited thereto. In another embodiment, the pixel circuit PC may not include the second capacitor C2, and one selected from the first conductive layer CL1 and the second conductive layer CL2 (e.g., the second conductive layer CL2) may be disposed below the first transistor T1 and may have a constant voltage level. In another embodiment, the data line DL and the driving voltage line PL may be located on the same layer (e.g., the fourth insulating layer 116).

The light-emitting diode LED may include a pixel electrode 210, an opposite electrode 230, and an intermediate layer 220 between the pixel electrode 210 and the opposite electrode 230.

Pixel electrodes 210 may be arranged spaced apart from each other on the fifth insulating layer 117. The pixel electrode 210 may include a reflective film including silver (Ag), magnesium (Mg), aluminum (Al), platinum (Pt), palladium (Pd), gold (Au), nickel (Ni), neodymium (Nd), iridium (Ir), chromium (Cr), or a compound thereof. In another embodiment, the pixel electrode 210 may further include a conductive oxide layer above and/or below the reflective film described above.

The bank layer 123 may be located on each of the pixel electrodes 210. The bank layer 123 may include a first opening 123OP overlapping each of the pixel electrodes 210. The bank layer 123 may include an insulating material, for example, an inorganic insulating material. The bank layer 123 may include silicon oxide, silicon nitride, and/or silicon oxynitride. Since the bank layer 123 includes an inorganic insulating material, damage to the light-emitting diode LED due to impurities such as moisture may be prevented.

The bank layer 123 may include a first overhang portion 123P disposed on an upper surface of each pixel electrode 210. When the display device 10 is viewed in a direction (e.g., z direction) perpendicular to an upper surface of the substrate 100 of FIG. 2 (or in a plan view), the first overhang portion 123P may entirely surround the first opening 123OP of the bank layer 123 while overlapping an upper surface of the pixel electrode 210. In other words, in a plan view, an inner portion of the pixel electrode 210 may overlap the first opening 123OP and an outer portion of the pixel electrode 210 may overlap the first overhang portion 123P.

The first overhang portion 123P may be spaced apart from the upper surface of the pixel electrode 210 along a direction (e.g., z direction) perpendicular to the upper surface of the pixel electrode 210. An inner portion of the pixel electrode 210 may overlap the first opening 123OP, and an outer portion of the pixel electrode 210 may overlap the first overhang portion 123P. The first overhang portion 123P overlapping the pixel electrode 210 may be spaced apart from the upper surface of the pixel electrode 210 along a direction perpendicular to the upper surface of the pixel electrode 210 (e.g., z-direction). Thus, a void (or gap or space) may be disposed locally between the upper surface of the pixel electrode 210 and a bottom surface of the first overhang portion 123P.

The bank structure layer 130 may be disposed on the bank layer 123. The bank structure layer 130 may include a second opening 130OP overlapping the first opening 123OP of the bank layer 123. In a plan view, the first openings 123OP of the bank layer 123 may be spaced apart from each other and arranged to overlap the pixel electrodes 210, respectively. The second openings 130OP of the bank structure layer 130 may be spaced apart from each other and arranged to overlap the pixel electrodes 210, respectively.

The bank structure layer 130 may include multiple layers. In an embodiment, FIG. 2 illustrates that the bank structure layer 130 includes a first layer 131 disposed on an upper surface of the bank layer 123 and a second layer 132 disposed on an upper surface of the first layer 131.

The bank structure layer 130 may have a stacked structure of an insulating material. For example, a first insulating material of the first layer 131 and a second insulating material of the second layer 132 may include different inorganic insulating materials from each other. In some embodiments, the first layer 131 may include silicon nitride, and the second layer 132 may include silicon oxide.

The bank structure layer 130 may include an overhang structure. For example, the second layer 132 may include a second overhang portion 132P protruding toward the second opening 130OP from a point mp where a bottom surface of the second layer 132 and a side surface of the first layer 131 meet.

When the display device 10 is viewed in a direction (e.g., z direction) perpendicular to the upper surface of the substrate 100 of FIG. 2 (or in a plan view), the second overhang portion 132P may entirely surround the second opening 130OP of the bank structure layer 130 while overlapping the upper surface of the bank layer 123.

Referring to FIG. 3, the bank layer 123 may cover an edge of the pixel electrode 210 and may be in direct contact with an edge portion of the pixel electrode 210. The first overhang portion 123P may be spaced apart from the upper surface 210u of the pixel electrode 210 to have a first vertical distance H1 in a direction (e.g., z direction) perpendicular to the upper surface 210u of the pixel electrode 210. A first length L1 of the first overhang portion 123P in the horizontal direction may be equal to or less than about 0.1 micrometers (µm). In some embodiments, the first length L1 of the first overhang portion 123P may be about 0.05 micrometers (µm) to about 0.1 micrometers (µm) (0.05 µm≤L1≤0.1 µm). In case that the first length L1 of the first overhang portion 123P in the horizontal direction is greater than about 0.1 micrometers (µm), a sagging of the first overhang portion 123P may occur. A first vertical distance H1 from the upper surface 210u of the pixel electrode 210 to the bottom surface of the first overhang portion 123P may be less than the first length L1 of the first overhang portion 123P described above.

The bank structure layer 130 may be disposed on the upper surface 123u of the bank layer 123. The bank structure layer 130 may include the first layer 131 and the second layer 132. A bottom surface of the first layer 131 may be in direct contact with the upper surface 123u of the bank layer 123, and a bottom surface of the second layer 132 may be in direct contact with the upper surface of the first layer 131. A thickness t1 of the first layer 131 may be greater than a thickness t2 of the second layer 132. In some embodiments, the thickness t1 of the first layer 131 may be in a range of about 800 angstroms (Å) to about 1,200 angstroms (Å) (800 Å ≤ t1 ≤ 1,200 Å), and the thickness t2 of the second layer 132 may be in a range of about 300 angstroms (Å) to about 700 angstroms (Å) (300 Å ≤ t2 ≤ 700 Å).

In some embodiments, a ratio (t2/t1) of the thickness t2 of the second layer 132 to the thickness t1 of the first layer 131 may be greater than about 0.4 and less than about 0.65 (0.4 < t2/t1 < 0.65). As a comparative example, in case that the ratio (t2/t1) of the thickness t2 of the second layer 132 to the thickness t1 of the first layer 131 exceeds the lower limit of the above-mentioned range, there may be a problem in that a second length L2 of the second overhang portion 132P may not be sufficiently secured. In case that the ratio (t2/t1) of the thickness t2 of the second layer 132 to the thickness t1 of the first layer 131 exceeds the upper limit of the above-mentioned range, there may be a problem in that the opposite electrode 230 is unintentionally separated by the second overhang portion 132P.

The second overhang portion 132P of the second layer 132 may protrude toward the second opening 130OP. In other words, the second overhang portion 132P of the second layer 132 may protrude toward an imaginary line CL passing through the center of the pixel electrode 210. The second length L2 of the second overhang portion 132P may be equal to or less than about 0.1 micrometers (µm). The second length L2 of the second overhang portion 132P may be in a range of about 0.05 micrometers (µm) to about 0.1 micrometers (µm) (0.05 µm ≤ L2 ≤ 0.1 µm).

The upper surface 123u of the bank layer 123 may include a stepped structure STP. For example, the upper surface 123u of the bank layer 123 may include a first portion 123ua overlapping the bank structure layer 130, a second portion 123ub forming a step with respect to the first portion 123ua, and an inclined portion (or a third portion) 123uc between the first portion 123ua and the second portion 123ub.

A first distance ds1 from the imaginary line CL passing through the center of the pixel electrode 210 to the stepped structure STP may be greater than a second distance ds2 from the imaginary line CL passing through the center of the pixel electrode 210 to a start point of the void (or gap or space) under the first overhang portion 123P. The first distance ds1 may denote a horizontal distance from the imaginary line CL passing through the center of the pixel electrode 210 to a point where the first portion 123ua and the inclined portion 123uc of the upper surface 123u of the bank layer 123 meet. The second distance ds2 may denote a horizontal distance from the imaginary line CL passing through the center of the pixel electrode 210 to a point where the upper surface of the pixel electrode 210 and a side surface 123IS of the bank layer 123 below the first overhang portion 123P of the bank layer 123 meet.

The second overhang portion 132P may, in some examples, not overlap the first overhang portion 123P, and may be disposed relatively farther from the pixel electrode 210 than the first overhang portion 123P is. For example, a third distance ds3 from the imaginary line CL perpendicular to the upper surface of the pixel electrode 210 and passing through the center of the pixel electrode 210 to the second overhang portion 132P may be greater than the second distance ds2 described above. The third distance ds3 from the imaginary line CL passing through the center of the pixel electrode 210 to the second overhang portion 132P may be substantially the same as the first distance ds1 described above.

The bank layer 123 may include the first overhang portion 123P, a first portion 123A overlapping the bank structure layer 130, and a second portion 123B between the first overhang portion 123P and the first portion 123A. The first portion 123A of the bank layer 123 may correspond to the first portion 123ua of the upper surface 123u of the bank layer 123 described above, and the second portion 123B of the bank layer 123 may correspond to the second portion 123ub of the upper surface 123u of the bank layer 123 described above.

A thickness t3 of the bank layer 123 may be greater than a thickness t4 (t4=t1+t2) of the bank structure layer 130. For example, the thickness t3 of the bank layer 123 may be measured as the thickness t3 of the first portion 123A of the bank layer 123. In some embodiments, the thickness t3 of the bank layer 123 may be greater than about twice the thickness t4 of the bank structure layer 130.

Referring to FIGS. 2 and 4, the intermediate layer 220 may include multiple light-emitting units (e.g., light-emitting sectors, or light-emitters). In an embodiment, FIG. 4 illustrates that the intermediate layer 220 includes two light-emitting units. For example, the intermediate layer 220 may include a first light-emitting unit 221, a second light-emitting unit 223, and a charge generation layer 222 between the first light-emitting unit 221 and the second light-emitting unit 223.

The first light-emitting unit 221 may include a first light-emitting functional layer 2212, a first lower common layer 2211 between the pixel electrode 210 and the first light-emitting functional layer 2212, and a first upper common layer 2213 between the first light-emitting functional layer 2212 and the charge generation layer 222.

The first lower common layer 2211 may include a hole injection layer (HIL). For example, the first lower common layer 2211 may include a P-type hole injection layer.

The first light-emitting functional layer 2212 may include an emission layer, or may include a multi-layer structure including an emission layer and an auxiliary layer. The emission layer may include a high-molecular-weight organic material or a low-molecular-weight organic material that emits light of a certain color (e.g., red light, green light, or blue light). The auxiliary layer may increase device efficiency by compensating for an optical resonance distance of light emitted from the emission layer. The auxiliary layer may include a resonance auxiliary material, for example, the same material as a hole transport layer.

The first upper common layer 2213 may include an electron transport layer (ETL). The first light-emitting functional layer 2212 may emit different light according to the corresponding light-emitting diode LED (FIG. 2). The first light-emitting functional layer 2212 of a light-emitting diode LED (FIG. 2) may be separated from the first light-emitting functional layer 2212 of another light-emitting diode LED (FIG. 2). The first lower common layer 2211 and the first upper common layer 2213 may be shared by multiple light-emitting diodes LED (FIG. 2). For example, each of the first lower common layer 2211 and the first upper common layer 2213 may be formed by using an open mask having an opening that has a size equal to or larger than a size of the display area DA (FIG. 2).

The charge generation layer 222 may include a negative charge generation layer 2221 and a positive charge generation layer 2222. The negative charge generation layer 2221 may be an N-type charge generation layer. The negative charge generation layer 2221 may supply electrons. The negative charge generation layer 2221 may include a host and a dopant. The positive charge generation layer 2222 may be a P-type charge generation layer. The positive charge generation layer 2222 may supply holes. The positive charge generation layer 2222 may include a host and a dopant.

The N-type charge generation layer may include an N-type dopant material and an N-type host material. The N-type dopant material may be a metal of group I or group II of the periodic table, an organic material capable of donating electrons, or a mixture thereof. For example, the N-type dopant material may be at least one of an alkali metal and an alkaline-earth metal. For example, the N-type charge generation layer may include, but is not limited to, an organic layer doped with an alkali metal such as lithium (Li), sodium (Na), potassium (K), or cesium (Cs), or an alkaline-earth metal such as magnesium (Mg), strontium (Sr), barium (Ba), or radium (Ra). The N-type host material may include a material that may transfer electrons. For example, the N-type host material may include a material including at least one of, but is not limited to, tris(8-hydroxyquinolino)aluminum (Alq3), 8-hydroxyquinolinolato-lithium (Liq), 2-(4-biphenylyl)-5-(4-tert-butylphenyl)-1,3,4-oxadiazole (PBD), 3-(4-biphenyl)4-phenyl-5-tert-butylphenyl-1,2,4-triazole (TAZ), spiro-PBD, bis(2-methyl-8-quinolinolate)-4-(phenylphenolato)aluminium (BAlq), SAlq, 2,2',2-(1,3,5-benzinetriyl)-tris(1-phenyl-1-H-benzimidazole) (TPBi), oxadiazole, triazole, phenanthroline, benzoxazole, and benzthiazole.

The P-type charge generation layer may include a P-type dopant material and a P-type host material. The P-type dopant material may include, but is not limited to, a metal oxide such as V₂O₅, MoOₓ, or WO₃, an organic material such as tetrafluoro-tetracyanoquinodimethane (F4-TCNQ), hexaazatriphenylene-hexacarbonitrile (HAT-CN), or hexaazatriphenylene, or a metallic material. The P-type host material may include a material capable of transferring holes. For example, the P-type host material may include a material including at least one of, but is not limited to, N,N-dinaphthyl-N,N'-diphenyl benzidine (N,N'-bis(naphthalene-1-yl)-N,N'-bis(phenyl)-2,2'-dimethylbenzidine) (NPD), N,N'-bis-(3-methylphenyl)-N,N'-bis-(phenyl)-benzidine (TPD), and 4,4',4-Tris(N-3-methylphenyl-N-phenyl-amino)-triphenylamine (MTDATA).

The second light-emitting unit 223 may include a second light-emitting functional layer 2232, a second lower common layer 2231 between the charge generation layer 222 and the second light-emitting functional layer 2232, and a second upper common layer 2233 between the second light-emitting functional layer 2232 and the opposite electrode 230.

The second lower common layer 2231 may include a hole transport layer (HTL).

The second light-emitting functional layer 2232 may include an emission layer, or may include a multi-layer structure including an emission layer and an auxiliary layer. The emission layer may include a high-molecular-weight organic material or a low-molecular-weight organic material, which emits light of a certain color (e.g., red light, green light, or blue light). The auxiliary layer may increase device efficiency by compensating for an optical resonance distance of light emitted from the emission layer. The auxiliary layer may include a resonance auxiliary material, for example, the same material as a hole transport layer. The second light-emitting functional layer 2232 and the first light-emitting functional layer 2212 corresponding to the same light-emitting diode LED (FIG. 2) may include an organic material that emits light of the same color.

The second upper common layer 2233 may include an electron transport layer (ETL). In some embodiments, the second upper common layer 2233 may include a multi-layered electron transport layer.

At least one sub-layer included in the intermediate layer 220 may include multiple portions separated from each other by the first overhang portion 123P and the second overhang portion 132P. FIG. 2 illustrates that the intermediate layer 220 includes multiple portions separated from each other by the first overhang portion 123P and the second overhang portion 132P.

In an embodiment, each of the first light-emitting unit 221 and the charge generation layer 222 of the intermediate layer 220 may include multiple portions separated from each other by the first overhang portion 123P and the second overhang portion 132P, and at least one of the sub-layers included in the second light-emitting unit 223 may include multiple portions separated from each other by the first overhang portion 123P and/or the second overhang portion 132P. For example, each of the second lower common layer 2231 and the second light-emitting functional layer 2232 of the second light-emitting unit 223 may include multiple portions separated from each other by the first overhang portion 123P and/or the second overhang portion 132P. In some embodiments, the second upper common layer 2233 may not be separated. In other embodiments, in case that the second upper common layer 2233 includes a multi-layered structure, at least one of the sub-layers (e.g., the uppermost layer) of the second upper common layer 2233 may be continuously formed without being separated by the first overhang portion 123P and/or the second overhang portion 132P.

In another embodiment, all sub-layers of the intermediate layer 220, for example, the first light-emitting unit 221, the charge generation layer 222, and the second light-emitting unit 223, may each include multiple portions separated from each other by the first overhang portion 123P and the second overhang portion 132P.

The opposite electrode 230 may be continuously formed without being separated by the first overhang portion 123P and the second overhang portion 132P. In other words, the opposite electrode 230 may be shared by multiple light-emitting diodes LED (FIG. 2). The opposite electrode 230 may be continuously formed to overlap multiple pixel electrodes 210. In other words, the opposite electrode 230 may be formed to continuously cover portions of the intermediate layer 220 that are separated from each other by the first overhang portion 123P and/or the second overhang portion 132P.

The opposite electrode 230 may include a conductive material having a low work function. The opposite electrode 230 may include a (semi-)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. In other embodiments, the opposite electrode 230 may further include a layer, such as ITO, IZO, ZnO, or In₂O₃, above the (semi)transparent layer including the materials stated above.

An upper layer 240 may be continuously formed, like the opposite electrode 230. The upper layer 240 may overlap multiple light-emitting diodes LED. The upper layer 240 may include a LiF layer and/or a capping layer, and the capping layer may be an organic capping layer including an organic material, an inorganic capping layer including an inorganic material, or an organic-inorganic composite capping layer including an organic material and an inorganic material. The capping layer may include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including oxygen (O), nitrogen (N), sulfur (S), selenium (Se), silicon (Si), fluorine (F), chlorine (CI), bromine (Br), indine (I), or any combination thereof.

Although not shown in FIG. 2, an encapsulation layer may be disposed on the upper layer 240. The encapsulation layer may include at least one inorganic encapsulation layer including an inorganic insulating material and at least one organic encapsulation layer including an organic insulating material. In an embodiment, the encapsulation layer may include a first inorganic encapsulation layer, a second inorganic encapsulation layer, and an organic encapsulation layer between the first inorganic encapsulation layer and the second inorganic encapsulation layer.

The display device 10 according to an embodiment may include the bank layer 123 and the bank structure layer 130 that include inorganic insulating materials, thereby preventing damage to the display device 10 due to moisture permeation in the high-resolution display device 10 having a relatively narrow gap between the light-emitting diodes LED. The display device 10 according to embodiments may include at least one sub-layer of the intermediate layer 220 separated through multiple overhang portions without being separated or disconnected from the opposite electrode 230, thereby preventing a voltage drop of the opposite electrode 230 and preventing an increase in the lateral leakage current due to a decrease in the distance between the light-emitting diodes LED.

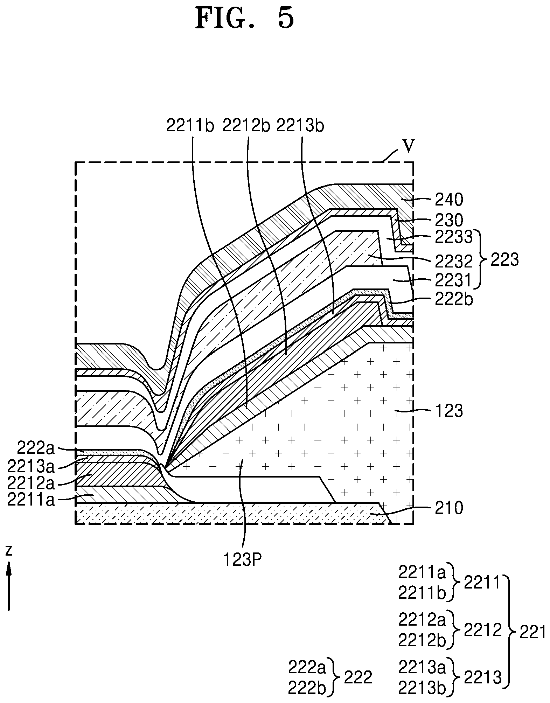

FIG. 5 is an enlarged schematic cross-sectional view of region V in part of the display device illustrated in FIG. 2, according to an embodiment.

Referring to FIG. 5, sub-layers corresponding to the first light-emitting unit 221 included in the intermediate layer 220 may be separated into multiple portions by the first overhang portion 123P. For example, the first lower common layer 2211, the first light-emitting functional layer 2212, and the first upper common layer 2213 may include multiple portions separated by the first overhang portion 123P, respectively.

The first lower common layer 2211 may include a first portion 2211a and a second portion 2211b separated by the first overhang portion 123P. The first portion 2211a of the first lower common layer 2211 may be disposed on the pixel electrode 210, and the second portion 2211b of the first lower common layer 2211 may be disposed on the first overhang portion 123P.

The first light-emitting functional layer 2212 may include a first portion 2212a and a second portion 2212b separated by the first overhang portion 123P. The first portion 2212a of the first light-emitting function layer 2212 may be disposed on the first portion 2211a of the first lower common layer 2211 to overlap the pixel electrode 210. The second portion 2212b of the first light-emitting functional layer 2212 may be disposed on the second portion 2211b of the first lower common layer 2211 to overlap the first overhang portion 123P.

The first upper common layer 2213 may include a first portion 2213a and a second portion 2213b separated by the first overhang portion 123P. The first portion 2213a of the first upper common layer 2213 may be disposed on the first portion 2212a of the first light-emitting functional layer 2212 to overlap the pixel electrode 210. The second portion 2213b of the first upper common layer 2213 may be disposed on the second portion 2212b of the first light-emitting functional layer 2212 to overlap the first overhang portion 123P.

The charge generation layer 222 may include a first portion 222a and a second portion 222b separated by a first overhang portion 123P. The first portion 222a of the charge generation layer 222 may be disposed on the first portion 2213a of the first upper common layer 2213 to overlap the pixel electrode 210. The second portion 222b of the charge generation layer 222 may be disposed on the second portion 2213b of the first upper common layer 2213 to overlap the first overhang portion 123P.

The sub-layers corresponding to the second light-emitting unit 223, such as the second lower common layer 2231, the second light-emitting functional layer 2232, and the second upper common layer 2233 may each not be separated into multiple portions by the first overhang portion 123P as shown in FIG. 5. In another embodiment, one or more sub-layers selected from the second lower common layer 2231, the second light-emitting functional layer 2232, and the second upper common layer 2233 (for example, the second lower common layer 2231, or the second lower common layer 2231 and the second light-emitting functional layer 2232) may include multiple portions separated by the first overhang portion 123P.

The opposite electrode 230 and the upper layer 240 may not be separated by the first overhang portion 123P, and may continuously overlap the first portion of each of the sub-layers of the first light-emitting unit 221 disposed on the pixel electrode 210 and the second portion of each of the sub-layers of the first light-emitting unit 221 disposed on the first overhang portion 123P. The opposite electrode 230 and the upper layer 240 may not be separated by the first overhang portion 123P, and may continuously overlap the first portion 222a of the charge generation layer 222 disposed on the pixel electrode 210 and the second portion 222b of the charge generation layer 222 disposed on the first overhang portion 123P.

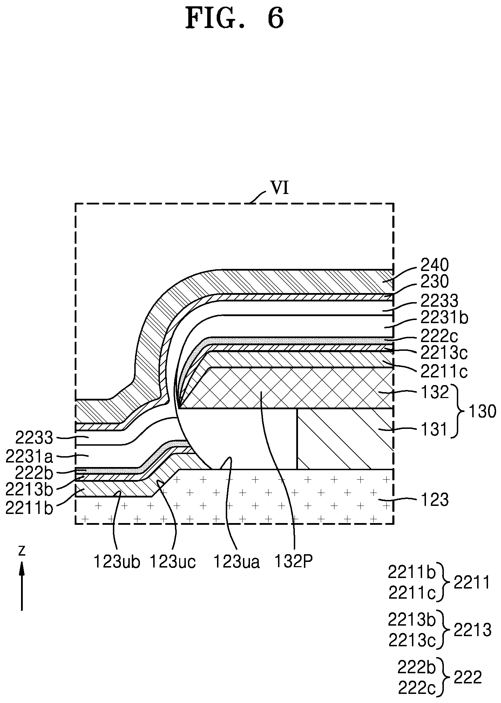

FIG. 5 shows that both the first light-emitting unit 221 and the charge generation layer 222 are separated by the first overhang portion 123P, but the disclosure is not limited thereto. In another embodiment, the charge generation layer 222 may not be separated by the first overhang portion 123P but may be separated by the second overhang portion 132P (FIG. 6), which will be described below with reference to FIG. 6. In another embodiment, not only the charge generation layer 222 but also at least one sub-layer that is relatively far from the pixel electrode 210 among the sub-layers of the first light-emitting unit 221 may not be separated into multiple portions by the first overhang portion 123P. For example, the first upper common layer 2213 and/or the first light-emitting functional layer 2212 may not be separated into multiple portions by the first overhang portion 123P. The first upper common layer 2213 and/or the first light-emitting functional layer 2212 may be separated into multiple portions by the second overhang portion 132P, which will be described below with reference to FIG. 6.

FIG. 6 is an enlarged schematic cross-sectional view of region VI of FIG. 2 according to an embodiment. FIG. 6 is an enlarged cross-sectional view of a region VI in the part of the display device illustrated in FIG. 2, according to an embodiment.

Referring to FIGS. 4 and 6, sub-layers included in the first light-emitting unit 221 of the intermediate layer 220, sub-layers included in the charge generation layer 222 of the intermediate layer 220, and sub-layers included in the second light-emitting unit 223 of the intermediate layer 220 may be separated into multiple portions by the second overhang portion 132P. In some embodiments, the first lower common layer 2211 and the first upper common layer 2213 of the first light-emitting unit 221, the charge generation layer 222, and the second lower common layer 2231 of the second light-emitting unit 223 may include multiple portions separated by the second overhang portion 132P, respectively. In another embodiment, the second upper common layer 2233 may include multiple portions separated by the second overhang portion 132P.

The first lower common layer 2211 may include the second portion 2211b and a third portion 2211c separated by the second overhang portion 132P. The second portion 2211b of the first lower common layer 2211 may be disposed on the bank layer 123. The third portion 2211c of the first lower common layer 2211 may be disposed on the second overhang portion 132P. Referring to FIGS. 5 and 6, the second portion 2211b of the first lower common layer 2211 may extend from the first overhang portion 123P (see FIG. 5) to the upper surface 123u of the bank layer 123 including the stepped structure STP (see FIG. 3). The second portion 2211b of the first lower common layer 2211 may be in direct contact with a part of the first portion 123ua of the upper surface 123u of the bank layer 123, the second portion 123ub and the inclined portion 123uc. In another embodiment, the second portion 2211b of the first lower common layer 2211 may not contact the first portion 123ua of the upper surface 123u of the bank layer 123.

The first upper common layer 2213 may include a second portion 2213b and a third portion 2213c separated by the second overhang portion 132P. The second portion 2213b of the first upper common layer 2213 may be disposed on the bank layer 123. Referring to FIGS. 5 and 6, the second portion 2213b of the first upper common layer 2213 may extend from the first overhang portion 123P (see FIG. 5) to the upper surface 123u of the bank layer 123 including the stepped structure STP (see FIG. 3). The third portion 2213c of the first upper common layer 2213 may be disposed on the second overhang portion 132P. An edge of the first light-emitting functional layer 2212 of the first light-emitting unit 221 may be located on the bank layer 123 as shown in FIG. 3, and in some embodiments, the second portion 2213b of the first upper common layer 2213 may be in direct contact with an upper surface of the second portion 2211b of the first lower common layer 2211 over the upper surface 123u of the bank layer 123, as shown in FIGS. 5 and 6. The third portion 2213c of the first upper common layer 2213 may be in direct contact with an upper surface of the third portion 2211c of the first lower common layer 2211 over the second overhang portion 132P.

In another embodiment, in case that the edge of the first light-emitting functional layer 2212 (see FIG. 5) of the first light-emitting unit 221 is located around the second overhang portion 132P, the second portion 2213b of the first upper common layer 2213 may not directly contact the upper surface of the second portion 2211b of the first lower common layer 2211.

The charge generation layer 222 may include a second portion 222b and a third portion 222c separated by the second overhang portion 132P. The second portion 222b of the charge generation layer 222 may overlap the bank layer 123 and may be disposed on the second portion 2213b of the first upper common layer 2213. Referring to FIGS. 5 and 6, the second portion 222b of the charge generation layer 222 may extend from the first overhang portion 123P (FIG. 5) to the upper surface 123u of the bank layer 123 including the stepped structure STP (see FIG. 3). The third portion 222c of the charge generation layer 222 may overlap the second overhang portion 132P. The second portion 222b of the charge generation layer 222 may be in direct contact with an upper surface of the second portion 2213b of the first upper common layer 2213. The third portion 222c of the charge generation layer 222 may be in direct contact with an upper surface of the third portion 2213c of the first upper common layer 2213.

The second lower common layer 2231 may include a first portion 2231a and a second portion 2231b separated by the second overhang portion 132P. The first portion 2231a of the second lower common layer 2231 may overlap the bank layer 123. The second portion 2231b of the second lower common layer 2231 may overlap the second overhang portion 132P. The first portion 2231a of the second lower common layer 2231 may be in direct contact with an upper surface of the second portion 222b of the charge generation layer 222. The second portion 2231b of the second lower common layer 2231 may be in direct contact with an upper surface of the third portion 222c of the charge generation layer 222.

The second upper common layer 2233 may not be separated by the second overhang portion 132P. A portion of the second upper common layer 2233 may be in direct contact with an upper surface of the first portion 2231a of the second lower common layer 2231, and another portion of the second upper common layer 2233 may be in direct contact with the upper surface of the second portion 2231b of the second lower common layer 2231.

The opposite electrode 230 and the upper layer 240 may not be separated by the second overhang portion 132P, and may continuously overlap the pixel electrode 210, the bank layer 123, and the bank structure layer 130.

FIG. 6 shows that the second upper common layer 2233 is not separated into multiple portions, but the disclosure is not limited to this. In another embodiment, the second upper common layer 2233 may include a first portion and a second portion separated by the second overhang portion 132P. The first portion of the second upper common layer 2233 may overlap the bank layer 123. The second portion of the second upper common layer 2233 may overlap the second overhang portion 132P. The first portion of the second upper common layer 2233 may be in direct contact with the upper surface of the first portion 2231a of the second lower common layer 2231. The second portion of the second upper common layer 2233 may be in direct contact with the upper surface of the second portion 2231b of the second lower common layer 2231 over the second overhang portion 132P.

In another embodiment, in case that the second upper common layer 2233 includes multiple sub-layers, at least one of the sub-layers of the second upper common layer 2233 may not be separated by the second overhang portion 132P and the remaining sub-layers of the second upper common layer 2233 may be separated into multiple portions by the second overhang portion 132P. For example, at least one of the above-described sub-layers that is disposed relatively close to the opposite electrode 230 may not be separated by the second overhang portion 132P. In another embodiment, the second upper common layer 2233 may not be completely separated.

As described with reference to FIGS. 5 and 6, the sub-layers of the intermediate layer 220, for example, at least the sub-layers of the first light-emitting unit 221 and the sub-layers of the charge generation layer 222 may be separated into multiple portions by the overhang portions (e.g., the first overhang portion 123P and the second overhang portion 132P), respectively, thereby effectively preventing an increase in lateral leakage current due to the above-described sub-layers.

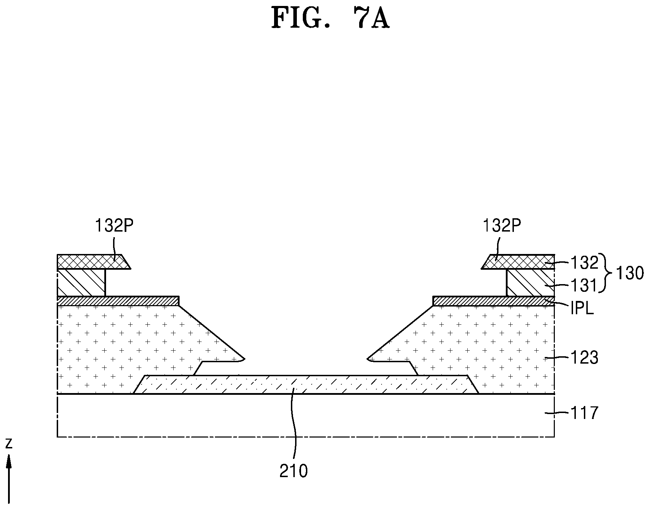

FIG. 7A is a schematic cross-sectional view of the bank layer 123 and the bank structure layer 130 of the display device 10 according to an embodiment.

According to the embodiment described with reference to FIG. 3, the bank structure layer 130 is shown in direct contact with the upper surface of the bank layer 123, but the disclosure is not limited thereto. In another embodiment, as shown in FIG. 7A, a protective layer IPL may be further disposed between the bank structure layer 130 and the bank layer 123.

The protective layer IPL may include a material such as a metal oxide, such as IZO or IGZO. Due to the structure of the protective layer IPL, the upper surface 123u of the bank layer 123 may not include the stepped structure STP (see FIG. 3). Except for the stepped structure caused by the protective layer IPL, the features of the bank structure layer 130 and the bank layer 123 shown in FIG. 7A may be the same as previously described with reference to FIG. 3.

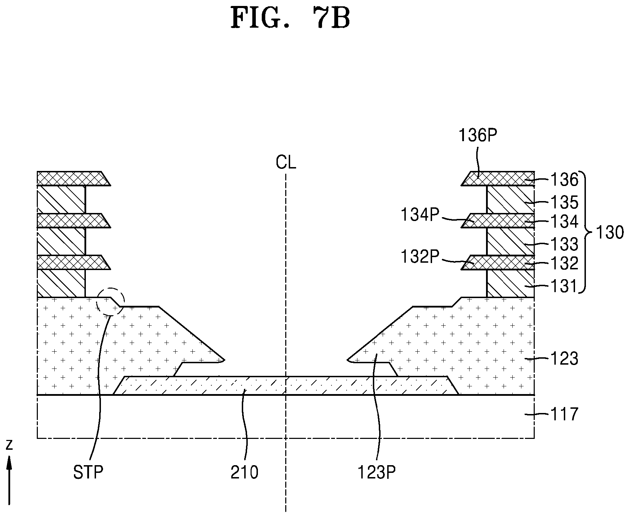

FIG. 7B is a schematic cross-sectional view illustrating the bank layer 123 and the bank structure layer 130 of the display device 10 according to an embodiment.

Referring to FIG. 7B, the bank structure layer 130 may include three or more layers. For example, the bank structure layer 130 may include the first layer 131, the second layer 132, a third layer 133, a fourth layer 134, a fifth layer 135, and a sixth layer 136. FIG. 7B shows six layers for convenience of explanation, but in another embodiment, the bank structure layer 130 may include four layers, such as the first layer 131, the second layer 132, the third layer 133, and the fourth layer 134. In another embodiment, the bank structure layer 130 may include seven or more layers.

The first layer 131, the second layer 132, the third layer 133, the fourth layer 134, the fifth layer 135, and the sixth layer 136 may include inorganic insulating materials such as silicon nitride, silicon oxide, and silicon oxynitride, respectively.

The first layer 131 and the second layer 132 may include different insulating materials, the third layer 133 and the fourth layer 134 may include different insulating materials, and the fifth layer 135 and the sixth layer 136 may include different insulating materials. The first layer 131, the third layer 133, and the fifth layer 135 may include the same insulating material, for example, silicon nitride. The second layer 132, fourth layer 134, and sixth layer 136 may include the same insulating material, for example, silicon oxide.

The thickness of the first layer 131 may be greater than the thickness of the second layer 132, the thickness of the third layer 133 may be greater than the thickness of the fourth layer 134, and the thickness of the fifth layer 135 may be greater than the thickness of the sixth layer 136.

In some embodiments, the ratio of the thickness of the second layer 132 to the thickness of the first layer 131 may be greater than about 0.4 and less than about 0.65. The ratio of the thickness of the fourth layer 134 to the thickness of the third layer 133 may be greater than about 0.4 and less than about 0.65. The ratio of the thickness of the sixth layer 136 to the thickness of the fifth layer 135 may be greater than about 0.4 and less than about 0.65. As a comparative example of the disclosure, there may be a problem of not sufficiently securing the second length L2 of the second overhang portion 132P in case that the above-mentioned ratio exceeds the lower limit of the range, and there may be a problem in which the opposite electrode 230 is unintentionally separated by the second overhang portion 132P in case that the above-mentioned ratio exceeds the upper limit of the range.

In some embodiments, the thickness of each of the first layer 131, third layer 133, and fifth layer 135 may be in a range of about 500 angstroms (Å) to about 1,000 angstroms (Å). In some embodiments, the thickness of each of second layer 132, fourth layer 134, and sixth layer 136 may be in a range of about 150 angstroms (Å) to about 450 angstroms (Å), or in a range of about 200 angstroms (Å) to about 400 angstroms (Å).

The second layer 132 may be disposed on an upper surface of the first layer 131 and may include the second overhang portion 132P. The fourth layer 134 may be disposed on an upper surface of the third layer 133 and may include a third overhang portion 134P. The sixth layer 136 may be disposed on an upper surface of the fifth layer 135 and may include a fourth overhang portion 136P.

The second overhang portion 132P may extend laterally from the point where the side surface of the first layer 131 and the bottom surface of the second layer 132 meet toward the imaginary line CL passing through the center of the pixel electrode 210. The third overhang portion 134P may extend laterally from a point where a side surface of the third layer 133 and the bottom surface of the fourth layer 134 meet toward the above-described imaginary line CL. The fourth overhang portion 136P may extend laterally from a point where a side surface of the fifth layer 135 and the bottom surface of the sixth layer 136 meet toward the above-described imaginary line CL.

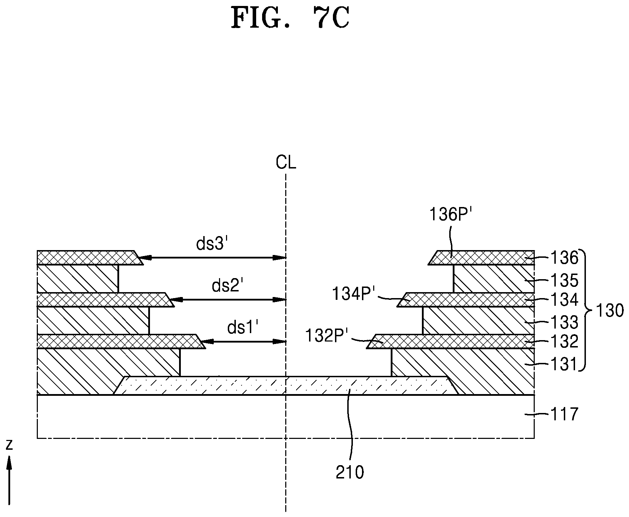

The second overhang portion 132P, the third overhang portion 134P, and the fourth overhang portion 136P may overlap each other. For example, the second overhang portion 132P, the third overhang portion 134P, and the fourth overhang portion 136P may be disposed on substantially the same vertical line (e.g., an imaginary line extending in a direction (e.g., z direction) perpendicular to the upper surface of the bank layer 123. In another embodiment, the second overhang portion 132P, the third overhang portion 134P, and the fourth overhang portion 136P may not be disposed on substantially the same vertical line. For example, the second overhang portion 132P, the third overhang portion 134P, and the fourth overhang portion 136P may not overlap each other, as will be described below with reference to FIG. 7C.

The upper surface 123u of the bank layer 123 may include the stepped structure STP as previously described with reference to FIG. 3. Features, except that the bank structure layer 130 includes three or more layers, may be the same as previously described with reference to FIG. 3.

FIG. 7B shows that the upper surface of the bank layer 123 includes the stepped structure STP, but the disclosure is not limited thereto. In another embodiment, the protective layer IPL described above with reference to FIG. 7A may be disposed between the bank layer 123 and the bank structure layer 130 shown in FIG. 7B. The upper surface of the bank layer 123 may not include the stepped structure STP.

FIG. 7C is a schematic cross-sectional view illustrating the bank layer 123 and the bank structure layer 130 of the display device 10 according to an embodiment.

According to the embodiment described above with reference to FIG. 3 or FIG. 7B, the bank layer 123 may be disposed between the bank structure layer 130 and the pixel electrode 210, but the disclosure is not limited thereto. As another example, as shown in FIG. 7C, the bank structure layer 130 may be disposed directly above the pixel electrode 210.

The bank structure layer 130 may include multiple layers. In this regard, FIG. 7C shows that the bank structure layer 130 includes the first layer 131, the second layer 132, the third layer 133, the fourth layer 134, the fifth layer 135, and a sixth layer 136. FIG. 7C shows six layers for convenience of explanation, but in another embodiment, the bank structure layer 130 may include four layers such as the first layer 131, the second layer 132, the third layer 133, and the fourth layer 134. In another embodiment, the bank structure layer 130 may include seven or more layers.

Each of the first layer 131, the second layer 132, the third layer 133, the fourth layer 134, the fifth layer 135, and the sixth layer 136 may include an inorganic insulating material such as silicon nitride, silicon oxide, and silicon oxynitride.

The first layer 131 and the second layer 132 may include different insulating materials, the third layer 133 and the fourth layer 134 may include different insulating materials, and the fifth layer 135 and the sixth layer 136 may include different insulating materials. The first layer 131, the third layer 133, and the fifth layer 135 may include the same insulating material, for example, silicon nitride. The second layer 132, fourth layer 134, and sixth layer 136 may include the same insulating material, for example, silicon oxide.

The first layer 131 may be in contact with an edge of the pixel electrode 210 and a portion of the upper surface (e.g., a part of the upper surface corresponding to the outer portion of the pixel electrode 210). The thickness of the first layer 131 may be greater than the thickness of the third layer 133 and the thickness of the fifth layer 135.

The thickness of the first layer 131 may be greater than the thickness of the second layer 132, the thickness of the third layer 133 may be greater than the thickness of the fourth layer 134, and the thickness of the fifth layer 135 may be greater than the thickness of the sixth layer 136. In some embodiments, the thickness of each of the first layer 131, the third layer 133, and the fifth layer 135 may be in a range of about 500 angstroms (Å) to about 1,000 angstroms (Å). In some embodiments, the thickness of each of the second layer 132, the fourth layer 134, and the sixth layer 136 may be in a range of about 100 angstroms (Å) to about 500 angstroms (Å), or in a range of about 200 angstroms (Å) to about 400 angstroms (Å).

The second layer 132 may be disposed on the upper surface of the first layer 131 and may include a first overhang portion 132P', the fourth layer 134 may be disposed on the upper surface of the third layer 133 and may include a second overhang portion 134P', and the sixth layer 136 may be disposed on the upper surface of the fifth layer 135 and may include a third overhang portion 136P'.

The first overhang portion 132P' may extend laterally from a point where the side surface of the first layer 131 and the bottom surface of the second layer 132 meet toward the imaginary line CL passing through the center of the pixel electrode 210. The second overhang portion 134P' may extend laterally from a point where the side surface of the third layer 133 and the bottom surface of the fourth layer 134 meet toward the aforementioned imaginary line CL. The third overhang portion 136P' may extend laterally from a point where the side surface of the fifth layer 135 and the bottom surface of the sixth layer 136 meet toward the imaginary line CL.

In this embodiment, the first overhang portion 132P', the second overhang portion 134P', and the third overhang portion 136P' may not overlap each other. For example, the first distance ds1' from the imaginary line CL extending in a direction perpendicular to the upper surface of the pixel electrode 210 and passing through the center of the pixel electrode 210 to the first overhang portion 132P' may be less than a second distance ds2' from the imaginary line CL to the second overhang portion 134P'. The second distance ds2' from the imaginary line CL to the second overhang portion 134P' may be less than the third distance ds3' from the imaginary line CL to the third overhang portion 136P'.

Through the structures of the bank layer 123 and the bank structure layer 130 described with reference to FIGS. 7A and 7B, the intermediate layer 220 (see FIG. 4) may include multiple portions separated by each of the overhang portions as described above with reference to FIGS. 5 and 6. Likewise, through the structure of the bank structure layer 130 described with reference to FIG. 7C, the intermediate layer 220 (see FIG. 4) may include multiple portions separated by the overhang portions as previously described with reference to FIGS. 5 and 6.

Sub-layers of the first light-emitting unit 221 (see FIG. 4), sub-layers of the charge generation layer 222 (see FIG. 4), and sub-layers (or at least one of the sub-layers) of the second light-emitting unit 223 (see FIG. 4) included in the intermediate layer 220 (see FIG. 4) may be separated into multiple portions by the overhang portions of the structure described with reference to FIGS. 7A to 7C, respectively, so that leakage current in the lateral direction through the intermediate layer 220 (see FIG. 4) may be effectively prevented. For example, the sub-layers of the intermediate layer 220, for example, at least the sub-layers of the first light-emitting unit 221 and the sub-layers of the charge generation layer 222 may each be separated into multiple portions by the overhang portions, and thus the increase in lateral leakage current due to the sub-layers can be effectively prevented.

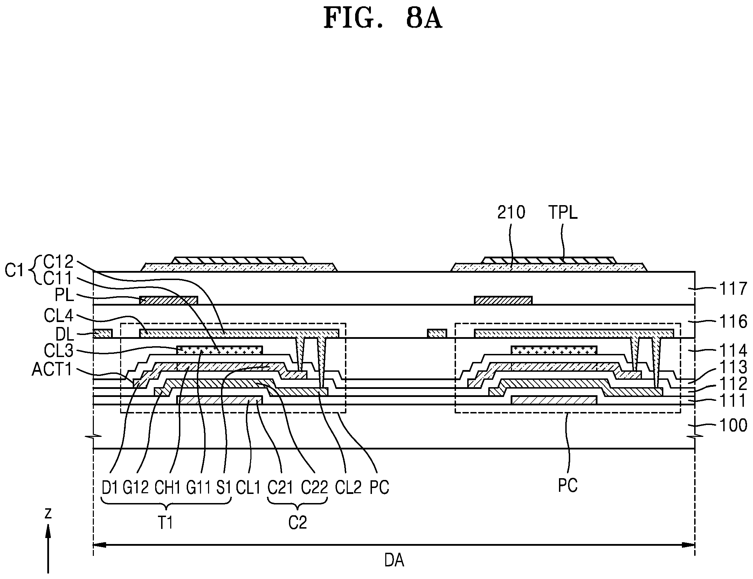

FIGS. 8A to 8F are schematic cross-sectional views of a manufacturing process for the display device 10 according to an embodiment.

Referring to FIG. 8A, pixel circuits PC may be formed on the substrate 100. The substrate 100, a specific structure of the pixel circuit PC, the buffer layer 111, and the first to fifth insulating layers 112, 113, 114, 116, and 117 may be the same as those described with reference to FIG. 2.

The pixel electrode 210 may be formed on the fifth insulating layer 117, and an upper protective layer TPL may be formed on the pixel electrode 210.

The pixel electrodes 210 may be spaced apart from each other, and the upper protective layer TPL may be disposed on each pixel electrode 210. In some embodiments, the upper protective layer TPL may be disposed only on the upper surface of the pixel electrode 210, but the disclosure is not limited thereto. In another embodiment, the upper protective layer TPL may extend beyond the edge of the pixel electrode 210 onto an upper surface of the fifth insulating layer 117.

The pixel electrode 210 may include a material such as that described with reference to FIG. 2. In an embodiment, the pixel electrode 210 may have a triple-layer structure in which an indium tin oxide (ITO) layer, a silver (Ag) layer, and an indium tin oxide (ITO) layer are stacked on each other.

The upper protective layer TPL may include metal oxide. The upper protective layer TPL may include zinc oxide (ZnO), indium zinc oxide (IZO), indium gallium zinc oxide (IGZO), or the like.

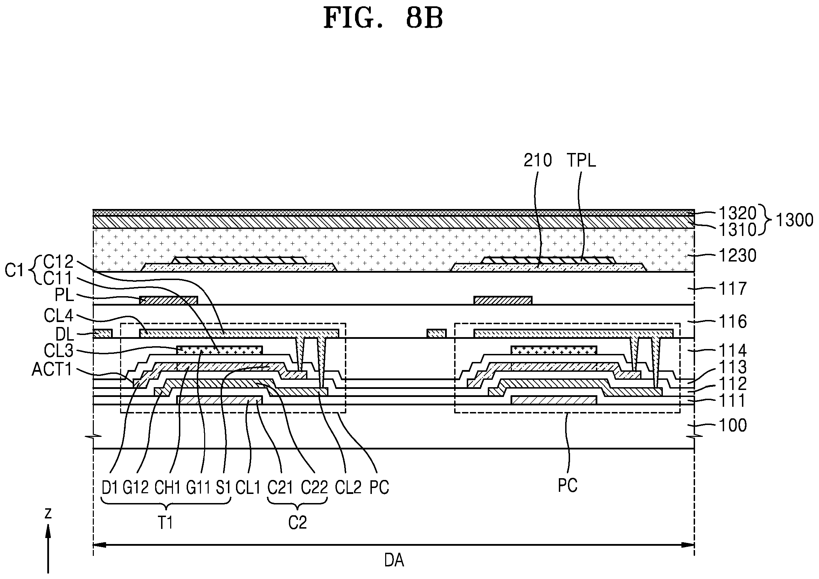

Referring to FIG. 8B, an insulating material layer 1230 may be formed on the structure described with reference to FIG. 8A, and a multi-layer insulating material layer 1300 may be formed on the insulating material layer 1230. The multi-layer insulating material layer 1300 may include a first sub-insulating material layer 1310 and a second sub-insulating material layer 1320. The insulating material layer 1230 and the multi-layer insulating material layer 1300 may each include an inorganic insulating layer such as silicon oxide, silicon oxynitride, and silicon nitride. The first sub-insulating material layer 1310 and the second sub-insulating material layer 1320 of the multi-layer insulating material layer 1300 may include different materials. For example, the first sub-insulating material layer 1310 may include silicon nitride, and the second sub-insulating material layer 1320 may include silicon oxide.

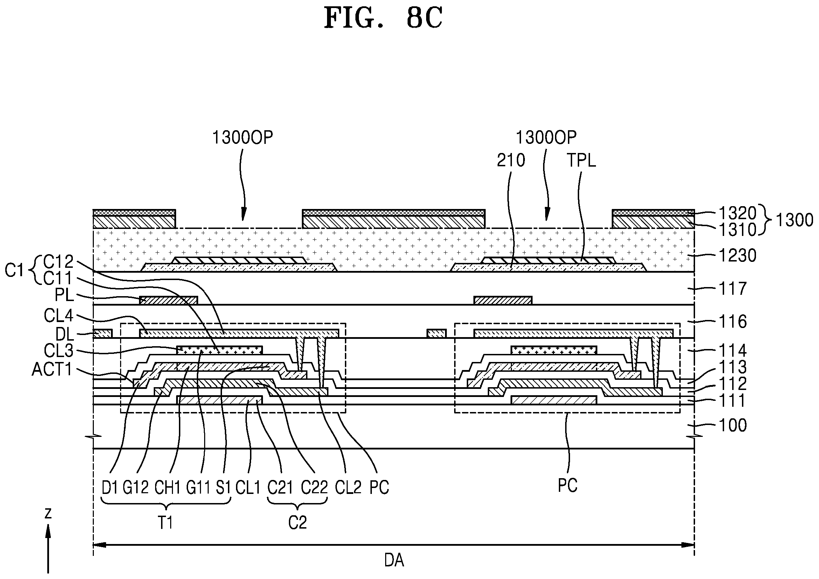

Referring to FIG. 8C, by removing a portion of the multi-layer insulating material layer 1300, an opening 1300OP that overlaps each pixel electrode 210 may be formed. The opening 1300OP may be formed through a first etching process using a first etching gas. The first etching gas may include octafluorocyclobutane (C₄F₈) and oxygen gas. Although the first sub-insulating material layer 1310 and the second sub-insulating material layer 1320 may include different materials, the etch rate for the first etching gas may be the same. Thus, as shown in FIG. 8C, the removed portion of the first sub-insulating material layer 1310 and the removed portion of the second sub-insulating material layer 1320 may have substantially the same width.

FIG. 8C shows that the opening 1300OP has the shape of a through hole penetrating from an upper surface to a bottom surface of the multi-layer insulating material layer 1300, but the disclosure is not limited thereto. In another embodiment, the depth of the opening 1300OP may be less than the thickness of the multi-layer insulating material layer 1300. In other words, the opening 1300OP may have the shape of a blind hole that does not penetrate from the upper surface to the bottom surface of the multi-layer insulating material layer 1300. For example, the opening 1300OP having the shape of a blind hole may penetrate from an upper surface to a bottom surface of the second sub-insulating material layer 1320, and may penetrate an upper surface of the first sub-insulating material layer 1310, but may not penetrate a bottom surface of the first sub-insulating material layer 1310.

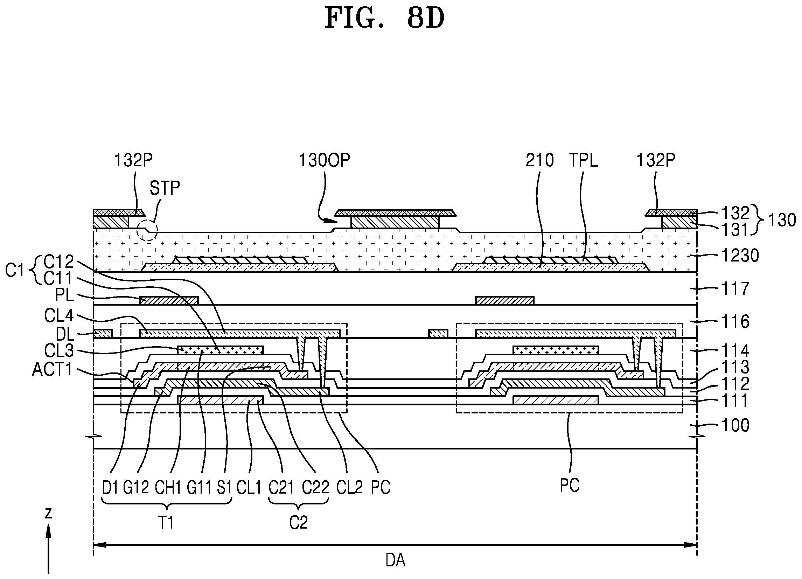

Referring to FIGS. 8C and 8D, the bank structure layer 130 having an overhang structure can be formed by removing a portion of the multi-layer insulating material layer 1300 in which the opening 1300OP is formed. For example, after the first etching process described with reference to FIG. 8C, the bank structure layer 130 including the second overhang portion 132P may be formed through a second etching process using a second etching gas. The second etching gas may include tetrafluoromethane (CF₄), oxygen, and argon gas. The etch rate of the first sub-insulating material layer 1310 and the etch rate of the second sub-insulating material layer 1320 with respect to the second etching gas used in the second etching process may be different from each other. Therefore, as the first sub-insulating material layer 1310 may be relatively over-etched relative to the second sub-insulating material layer 1320, the second layer 132 including the second overhang portion 132P and the first layer 131 of the bank structure layer 130 may be formed.

The bank structure layer 130 formed in the second etching process may include the second opening 130OP that overlaps each pixel electrode 210. In the second etching process, a portion of an upper surface of the insulating material layer 1230 may be removed, and thus, as shown in FIG. 8D, an upper surface of the insulating material layer 1230 may include the stepped structure STP. The position of the step structure STP may be located on the same vertical line as the edge of the second overhang portion 132P or located around the second overhang portion 132P, as previously described with reference to FIG. 3.

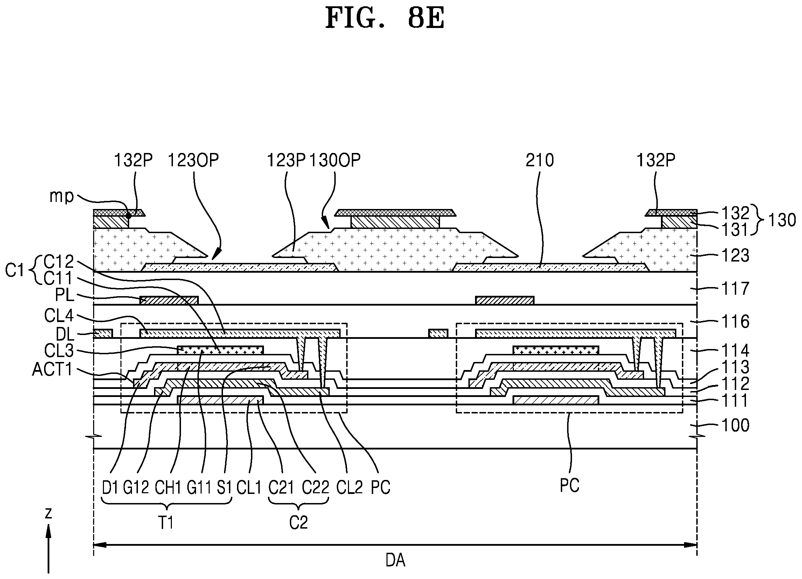

Referring to FIG. 8E, the bank layer 123 having the first opening 123OP may be formed by removing a portion of the insulating material layer 1230 through the second opening 130OP of the bank structure layer 130. Thereafter, by removing the upper protective layer TPL through the first opening 123OP of the bank layer 123, the bank layer 123 may include a first overhang portion 123P. The specific structure of the bank layer 123 including the first overhang portion 123P and the bank structure layer 130 including the second overhang portion 132P may be the same as that previously described with reference to FIG. 3.

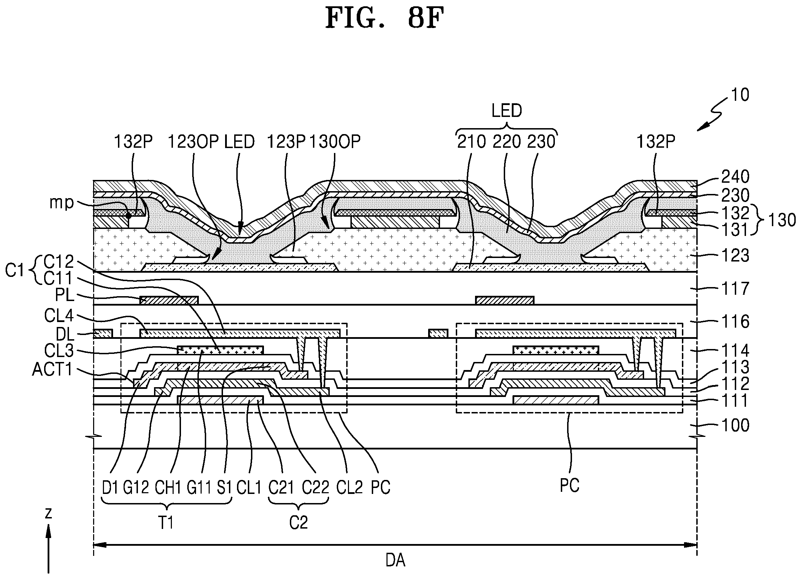

Referring to FIG. 8F, the intermediate layer 220, the opposite electrode 230, and the upper layer 240 may be formed on the structure described with reference to FIG. 8E. The intermediate layer 220 may include multiple sub-layers as described with reference to FIG. 4, and the multiple sub-layers may include multiple portions separated by the overhang portions as described with reference to FIGS. 5 and 6. The sub-layers included in the intermediate layer 220 may be separated into multiple portions with respect to the first overhang portion 123P and the second overhang portion 132P, thereby preventing current leakage through the sub-layer(s) of the intermediate layer 220. In some embodiments, the first light-emitting unit 221 (see FIG. 4) and the charge generation layer 222 (see FIG. 4) of the intermediate layer 220 may be separated with respect to the first overhang portion 123P and the second overhang portion 132P, respectively. In another embodiment, the sub-layers of the first light-emitting unit 221 (see FIG. 4), the sub-layers of the charge generation layer 222 (see FIG. 4) , and the sub-layers of the second light-emitting unit 223(see FIG. 4) of the intermediate layer 220 may be separated into multiple portions with respect to the first overhang portion 123P and the second overhang portion 132P, respectively. In another embodiment, each of the first light-emitting unit 221 (see FIG. 4) and the charge generation layer 222 (see FIG. 4) may be separated into multiple portions with respect to the first overhang portion 123P and the second overhang portion 132P, and at least one selected from among the sub-layers of the second light-emitting unit 223 (see FIG. 4) may be separated into multiple portions with respect to the first overhang portion 123P and the second overhang portion 132P.

By forming the opposite electrode 230 continuously without being separated, a voltage drop of the opposite electrode 230 may be prevented. The upper layer 240 may also be formed continuously without being separated.

According to an embodiment of the disclosure, the generation of lateral leakage current due to the reduced space between light-emitting diodes at high resolution may be reduced by separating the sub-layers arranged in the intermediate layer through the overhang portions of the bank layer and the bank structure layer. The effects described above are examples and the effects of one or more embodiments are not limited to those described above.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure.

## Claims

1. A display device, comprising:
a pixel electrode;
a bank layer including an inorganic insulating material, a first opening, and a first overhang portion, the first opening overlapping the pixel electrode, and the first overhang portion being disposed over an upper surface of the pixel electrode;
a bank structure layer disposed on the bank layer and including a second opening overlapping the first opening;
an intermediate layer overlapping the pixel electrode through the first opening and the second opening; and
an opposite electrode disposed on the intermediate layer, wherein
the bank structure layer includes:
a first layer disposed on an upper surface of the bank layer and including a first insulating material, and
a second layer disposed on an upper surface of the first layer and including a second insulating material, the second layer including a second overhang portion protruding toward a center of the second opening from a point where a bottom surface of the second layer and a side surface of the first layer meet,
sub-layers of the intermediate layer include a plurality of portions separated by the first overhang portion and the second overhang portion, and
the opposite electrode overlaps the plurality of portions.

2. The display device of claim 1, wherein
the intermediate layer comprises:
a charge generation layer;
a first light-emitting unit between the charge generation layer and the pixel electrode; and
a second light-emitting unit between the charge generation layer and the opposite electrode,
sub-layers of the first light-emitting unit each include portions separated by the first overhang portion and the second overhang portion, and
the charge generation layer includes portions separated by the first overhang portion and the second overhang portion.

3. The display device of claim 2, wherein
at least one of sub-layers of the second light-emitting unit includes portions separated by the first overhang portion and the second overhang portion.

4. The display device of any preceding claim, wherein
a thickness of a portion of the bank layer that overlaps the bank structure layer is greater than a thickness of the bank structure layer.

5. The display device of any preceding claim, wherein
a first thickness of the first layer is greater than a second thickness of the second layer;
optionally wherein:
(i) the first thickness of the first layer is in a range of about 800 angstroms to about 1,200 angstroms; and/or
(ii) a ratio (t2/t1) of the second thickness (t2) of the second layer to the first thickness (t1) of the first layer satisfies 0.4 < t2/t1 < 0.65.

6. The display device of any preceding claim, wherein
a length of the second overhang portion is in a range of about 0.05 micrometers to about 0.1 micrometers.

7. The display device of any preceding claim, wherein
the first overhang portion and the second overhang portion do not overlap each other when viewed in a direction perpendicular to an upper surface of the pixel electrode.

8. The display device of any preceding claim, wherein
the upper surface of the bank layer includes:
a first portion overlapping the bank structure layer; and
a second portion forming a step with respect to the first portion;
optionally wherein
in a cross-sectional view, a horizontal distance from an imaginary line passing through a center of the pixel electrode to the step is greater than a horizontal distance from the imaginary line to a point where the bank layer and the pixel electrode contact each other.

9. The display device of any preceding claim, further comprising:
a protective layer between the upper surface of the bank layer and a bottom surface of the bank structure layer.

10. The display device of any preceding claim, wherein
the bank structure layer further comprises:
a third layer disposed on the second layer; and
a fourth layer disposed on the third layer,
the fourth layer includes a third overhang portion protruding toward the center of the second opening from a point where a bottom surface of the fourth layer and a side surface of the third layer meet.

11. A display device, comprising:
a pixel electrode;
a bank structure layer disposed on the pixel electrode and including a first opening overlapping the pixel electrode;
an intermediate layer overlapping the pixel electrode through the first opening of the bank structure layer; and
an opposite electrode on the intermediate layer, wherein
the bank structure layer comprises:
a first layer comprising a first insulating material;
a second layer disposed on an upper surface of the first layer and comprising a second insulating material;
a third layer disposed on an upper surface of the second layer and comprising a third insulating material; and
a fourth layer disposed on an upper surface of the third layer and including a fourth insulating material,
the second layer includes a first overhang portion protruding toward a center of the first opening from a point where a bottom surface of the second layer and a side surface of the first layer meet,
the fourth layer includes a second overhang portion protruding toward the center of the first opening from a point where a bottom surface of the fourth layer and a side surface of the third layer meet, and
sub-layers included in the intermediate layer include portions separated by the first overhang portion and the second overhang portion.

12. The display device of claim 11, wherein
the first insulating material and the third insulating material are same as each other, and
the second insulating material and the fourth insulating material are same as each other.

13. The display device of claim 11 or claim 12, wherein
at least one selected from the first layer and the third layer has a thickness in a range of about 500 angstroms to about 1,000 angstroms.

14. The display device of any of claims 11 to 13, wherein
(i) the first overhang portion and the second overhang portion do not overlap each other; and/or
(ii) wherein
in a cross-sectional view, a horizontal distance from an imaginary line passing through a center of the pixel electrode to the first overhang portion is less than a horizontal distance from the imaginary line to the second overhang portion.

15. The display device of any of claims 11 to 14, further comprising:
a bank layer between the pixel electrode and the bank structure layer and including a second opening overlapping the first opening of the bank structure layer;
optionally wherein the bank layer comprises:
an overhang portion disposed on an upper surface of the pixel electrode.
